# EUROPEAN PATENT APPLICATION

(11) **EP 4 300 122 A1**
(43) Date of publication of application: **03.01.2024**
(21) Application number: 22181885.9
(22) Date of filing: 29.06.2022
(51) Int. Cl.: G01R 33/385, G01R 33/421, G01R 33/3815

(54) **MAGNETIC RESONANCE IMAGING DEVICE AND METHOD FOR DESIGNING A SHIELDING ASSEMBLY FOR A MAGNETIC RESONANCE IMAGING DEVICE**

(71) Applicant: Siemens Healthcare GmbH, 91052 Erlangen (DE)
(72) Inventor: DIETZ, Peter, 90762 Fürth (DE)
(74) Representative: Siemens Healthineers Patent Attorneys

(57) **Abstract**

Magnetic resonance imaging device (1, 1', 1"), comprising
- a superconducting main field coil assembly inside a vacuum vessel (2) of a cryogenic assembly, wherein the vacuum vessel (2) defines a cylindric patient bore (8), in which a homogeneity volume (10) of a main field created by the superconducting main field coil assembly is located, and
- an, in particular not actively shielded, cylindrical gradient coil assembly (11) having at least one gradient coil and being located inside the patient bore (8), wherein the cryogenic assembly comprises a shielding assembly to shield the main field coil assembly from stray fields of the gradient coil assembly (11),
wherein
- the main field coil assembly comprises multiple superconducting coils (4, 5, 6, 21) successively arranged inside the vacuum vessel (2) along a longitudinal direction (9) of the patient bore (8), wherein at least one pair of superconducting coils (4, 5, 6, 21) are distanced in the longitudinal direction (9) to form a longitudinally extending transparency region (13), and
- the shielding assembly comprises multiple shielding rings (16, 18, 19, 20) pairwise longitudinally separated by one of the at least one transparency region (13).

## Description

The invention concerns a magnetic resonance imaging device, comprising
- a superconducting main field coil assembly inside a vacuum vessel of a cryogenic assembly, wherein the vacuum vessel defines a cylindric patient bore, in which a homogeneity volume of a main field created by the superconducting main field coil assembly is located, and
- an, in particular not actively shielded, cylindrical gradient coil assembly having at least one gradient coil and being located inside the patient bore, wherein the cryogenic assembly comprises a shielding assembly to shield the main field coil assembly from stray fields of the gradient coil assembly.

The invention further concerns a method for designing a shielding assembly for such a magnetic resonance imaging device.

Magnetic resonance imaging (MRI) has become an often-used tool in medical technology, in particular diagnostics. In modern magnetic resonance imaging devices, the main field (also main magnetic field B0) is generated by a superconducting main field coil assembly. To maintain the superconducting state, the superconducting main field coil assembly is located in a cryogenic assembly, in particular a cryostat, of the magnetic resonance imaging device, usually comprising an outer vacuum vessel (or outer vacuum container, OVC), a thermal shield (often called cryogenic shield or, shortly, cryoshield) and an inner cooling medium vessel or chamber comprising a cooling medium like helium and the superconducting coils of the main field coil assembly. To provide spatial resolution and for other purposes, the magnetic resonance imaging device further comprises a gradient coil assembly, which usually comprises multiple gradient coils adapted to generate a linear magnetic field gradient in a corresponding, in particular cartesian, direction. The cryogenic assembly or the vacuum vessel, respectively, define a cylindrical patient bore into which a patient can be introduced using a patient table. The gradient coil assembly is usually provided radially adjacent to the cryogenic assembly in the patient bore, wherein, to smaller radii, a radio frequency coil assembly (for example a body coil and/or birdcage coil) may follow.

The longitudinal axis of the patient bore is usually called the Z direction, wherein the vertical direction orthogonal to the longitudinal direction is called the Y direction and the horizontal direction orthogonal to the longitudinal direction is usually called the X direction. Gradient coil assemblies of known magnetic resonance imaging devices often have gradient coils for the Z direction, the X direction, and the Y direction.

The purpose of the gradient coils of the gradient coil assembly in magnetic resonance imaging is to produce, in particular dynamic, gradient fields in the homogeneity volume, which corresponds to the field of view of the magnetic resonance imaging device. Inevitably, the gradient coils also produce stray fields, in particular on the radially outer side of the gradient coils. Such stray fields may influence the cryogenic assembly and the superconducting main field coil assembly. In particular, the stray fields induce eddy currents in conductive material. Such eddy currents (and hence the stray fields) have two main effects. As a first effect, eddy currents produce ohmic heat, and as a second effect, eddy currents create their own magnetic fields, which may disturb magnetic resonance imaging and are hence called disturbance fields in the following.

Regarding the first effect, heat, the temperature in some regions of the cryogenic assembly may rise, in particular where the superconducting coils of the main field coil assembly are located. If the temperature at the superconducting coils exceeds their T_{c}, a quench will occur. Regarding the second effect, magnetic field generation, any unintended magnetic field has the potential to disturb the image quality of magnetic resonance imaging. In particular, time varying disturbance fields or more complex spatial variation, in particular of higher order than one (non-linear disturbance fields) are known to cause severe issues, in particular artifacts in magnetic resonance images.

While in the pioneer days of magnetic resonance imaging, not actively shielded gradient coils have often been used, the increase of required gradient performance and the sophistication of applications require shielding measures, in particular to prevent the excessive generation of heat at the superconducting coils. In this context, it is known to enclose the superconducting coils of the main field coil assembly inside an at least substantially closed electrically conducting surface to shield it from outside influences, in particular stray fields of the gradient coil assembly. For example, a cryoshield (thermal shield) located between the vacuum vessel and the main field coil assembly, can be used to provide such a closed conductive layer, but it has additionally or alternatively been proposed to implement the closed conductive layer on or as the inner cooling medium vessel, in particular helium vessel, and/or the vacuum vessel and/or magnet formers. While it has also been proposed to try to minimize the strength of stray fields in the region of the superconducting coils, some remaining stray fields still exist, causing eddy currents and hence disturbance fields as a "price" for the shielding of the superconducting coils.

Hence, to resolve this issue, actively shielded gradient coil assemblies have been proposed to reduce the amount of stray field regarding the cryogenic assembly. For example, active shielding coils may form an additional radial layer radially outside the gradient coils, however largely increasing room required by the magnetic resonance imaging device and complicating its construction. For example, such an active shielding layer of a gradient coil assembly may have a radial extension of multiple centimeters. Here, main field creation by the superconducting main field coil assembly becomes less efficient due to larger distance from the homogeneity volume. Furthermore, using actively shielded gradient coil assemblies requires additional power and energy to supply the required compensation currents and compensation voltages. Also in this case, heat is generated, in particular regarding the wiring.

Regarding disturbance fields, in particular the compensation of linear eddy current fields, eddy current compensation (ECC) measures have also been proposed in the state of the art. Linear disturbance fields can be compensated by using gradient coils of the gradient coil assembly themselves, since these coils have been designed to create linear fields in the homogeneity volume and can hence create fields that destructively superimpose onto the linear disturbance fields. Hence, ECC algorithms can be employed to modify gradient pulses such that linear disturbance fields may, at least partly, be compensated. However, higher order disturbance fields may still remain an issue.

If not actively shielded gradient coil assemblies would be used in known magnetic resonance imaging devices, magnetic resonance imaging would become impossible due to extremely high disturbance fields. If, however, the closed conductive layers in the cryogenic assembly, which carry the eddy currents from which the disturbance fields originate, would be omitted, the superconducting coils would be exposed to the stray field of the gradient coil assembly, such that heat would be generated and a quench would occur.

US 2021/0223339 A1 discloses systems and methods for magnetic resonance imaging. Here, a superconducting coil assembly forming a main magnetic field may comprise a magnetic field shielding apparatus to shield the superconducting coil assembly from a stray field of the gradient coil assembly, wherein the magnetic field shielding apparatus may include a conductive shielding component, a shielding cylinder, or a combination thereof.

It is an object of the current invention to provide an improved magnetic resonance imaging device requiring no active shielding of the gradient coil assembly.

This object is achieved by providing a magnetic resonance imaging device according to claim 1 and a method according to claim 15. Advantageous embodiments are described by the dependent claims.

In a magnetic resonance imaging device as initially described,
- the main field coil assembly comprises multiple superconducting coils successively arranged inside the vacuum vessel along a longitudinal direction of the patient bore, wherein at least one pair of superconducting coils are distanced in the longitudinal direction to form a longitudinally extending transparency region, and
- the shielding assembly comprises multiple shielding rings pairwise longitudinally separated by one of the at least one transparency region.

Generally speaking, the cryogenic assembly (cryostat) may comprise at least the vacuum vessel as outer vacuum container (OVC), wherein the superconducting coils of the main field coil assembly may be located inside an inner cooling medium vessel, in particular a helium vessel. Such a cooling medium vessel may not only comprise the superconducting coils, but may also be filled with the cooling medium, for example helium. To provide better thermal shielding, a thermal shield (cryoshield) may additionally be provided between the inner cooling medium vessel and the outer vacuum vessel, wherein the thermal shield usually encloses the main field coil assembly in the vacuum vessel.

The invention proposes to take a new approach to the handling of stray fields of gradient coil assemblies. The inventors have noticed that, in the state of the art, the two main effects discussed above, namely heat generation and disturbance fields, are tackled successively by first, in particular optimally, protecting the superconducting coils from quenching and then deal with the large amount of disturbance fields generated on the closed conductive layer surrounding the main field coil assembly by using active shielding to compensate disturbance fields. According to the invention, however, both effects, namely shielding the superconducting coils and to produce a minimum amount of disturbance fields in the homogeneity volume are addressed simultaneously. It is hence not tried to solve one issue first and mitigate the unaddressed issue as a second step.

To this end, a certain design of the cryogenic assembly and the main field coil assembly is proposed as a prerequisite, namely that the superconducting coils of the main coil assembly do not completely longitudinally fill the extent covered by the cryogenic assembly, but transparency regions are provided in which electrically conductive material and/or eddy currents generating (relevant) disturbance fields in the homogeneity volume are minimized. In other words, multiple superconducting coils are provided as part of the main field coil assembly leaving a distance between longitudinally adjacent coils. Once such transparency regions, where no or at least no relevant eddy currents can be induced, exists, the gradient coil assembly design may provide for the stray fields to be mainly located in these transparency regions.

Hence, in especially preferred embodiments of the invention, the gradient coils of the gradient coil assembly, in particular the transversal gradient coils, are, in particular based on an optimization result, configured such that the stray fields are mainly located in the at least one transparency region, in particular such that at least 70 % of the magnetic field strength of the stray fields is generated in the transparency region. In particular, the gradient coils of the gradient coil assembly, in particular the transversal gradient coils, may be configured, in particular regarding their conductors, such that the maximum magnetic field strength of their stray fields is higher in the at least one transparency region of the vacuum vessel than outside the at least one transparency region of the vacuum vessel and/or the average magnetic field strength of the stray fields is higher in the at least one transparency region of the vacuum vessel than outside the at least one transparency region in the vacuum vessel and/or the magnetic flux through a defined area size is higher in the at least one transparency region of the vacuum vessel than outside the transparency region in the vacuum vessel. As known from the art, the windings/conductors of the gradient coils and their course can be determined by an optimization algorithm yielding an optimization result. It can be shown that, even if only one layer of conductors of gradient coils is used, gradient coils can be designed such that as much of the stray field of the gradient coil assembly as possible is directed to the transparency regions, where no superconducting coils are present in a radial direction. For example, corresponding terms of the target function in the optimization algorithm and/or boundary conditions in the optimization algorithm can be accordingly provided. The presence of the transparency regions is hence exploited in that the stray fields of the gradient coil assembly are mostly generated in these transparency regions and/or directed thereto, respectively.

In a more concrete, exemplary approach, the superconducting coils may comprise at least two main superconducting coils located in opposing longitudinal end regions of the cryogenic assembly, wherein the conductors of at least the transversal gradient coils of the gradient coil assembly only extend in a longitudinal conductor region between the two longitudinal end regions. The at least two main superconducting coils may, for example, be the at least two superconducting coils generating the largest portion of the main magnetic field and/or having the greatest conductor length/extension, that is, the greatest amount of superconductor. It can be shown that good results are achieved by symmetrically providing two larger, main superconducting coils in the longitudinal end regions and placing some smaller superconducting coils elsewhere to produce an optimal homogeneity of the main magnetic field in the homogeneity volume. In such a design, at least the transversal gradient coils of the gradient coil assembly may be designed such that they are longitudinally shorter, that is, have a lesser extent in the Z direction, to not longitudinally overlap with the main superconducting coils. This can, for example, be achieved by guiding return conductors of the gradient coils, in particular the transversal gradient coils, closer to each other. Such return conductors (or return wires) of transversal gradient coils, that is, gradient coils producing a field gradient in the X (horizontal) and Y (vertical) directions, do not or at least not substantially contribute to the linear field form of the gradient field and can hence be redesigned in their course to allow a shorter gradient coil assembly. Furthermore, placing the return conductors closer together to have a shorter gradient coil assembly may increase heat generation and inductance in the respective gradient coil, however, since no active shielding layer is used, compared to an actively shielded gradient coil assembly, the inductance and heat generation are significantly lower anyway, so that this effect is tolerable.

Regarding the transparency region, "transparent" may be defined as avoiding the generation of eddy currents that create disturbance fields, which may disturb magnetic resonance imaging. Hence, preferably, all components of the cryogenic assembly inside the transparency region may be configured such that at least eddy currents due to stray fields of the gradient coil assembly, which create, in particular non-compensable, disturbance fields, in particular of order higher than one, disturbing the magnetic resonance imaging, in particular all eddy currents due to stray fields of the gradient coil assembly, are at least partially prevented, in particular at least substantially prevented. In concrete embodiments, it may be provided that at least a part of the components, in particular all components, of the cryogenic assembly in the transparency region at least radially inside of the superconducting coils comprise no electrically conductive material. However, to avoid disturbance fields, it is not in all cases necessary to avoid eddy currents or even electrically conductive material. For example, thin conductive structures do not pick up large amounts of stray fields as the overall area of a thin conductive structure exposed to the stray fields is small. In addition, for imaging only the longitudinal components the disturbance fields is relevant, such that conductive structures mainly extending in longitudinal direction (Z direction) can be employed, even if significant eddy currents are generated, because such longitudinal eddy currents do not produce longitudinal magnetic field components. Hence, imaging is not compromised. In other words, in preferred embodiments, electrically conductive material in the at least one transparency region may extend mainly in the longitudinal direction, in particular having a radial or circumferential extension of less than 5 mm. As a final note, eddy currents having extremely short or very long time constants are also less critical regarding disturbance of magnetic resonance imaging. Hence, in embodiments, at least a part of the components, in particular all components, of the cryogenic assembly may comprise only electrically conductive material, in which the time constant of the decay of eddy currents induced by stray fields of the gradient coil assembly is lower than a threshold value, in particular 2 ms, in each transparency region.

Generally speaking, the invention proposes to use shielding rings instead of a closed conductive surface on the radially inner side of the superconducting coils, that is, between the superconducting coils and the gradient coil assembly. These shielding rings extend at least over the longitudinal extension of the superconducting coils and are separated in transparency regions. In this manner, the superconducting coils are shielded from the stray fields of the gradient coil assembly since they are positioned behind a closed electrically conductive surface of at least one shielding ring. Since this closed electrically conductive surface is not required in the transparency regions, an additional degree of freedom in design results, since there is no need to generally reduce the stray fields, in particular in the transparency regions. The focus, however, is still to minimize the immission of stray fields to the superconducting coils, while the emission of stray fields from the gradient coil assembly is generally accepted. Proper local shielding by the shielding rings can be provided by positioning the shielding rings strategically to "catch" most of the incoming stray field lines of the stray fields of the gradient coil assembly that would otherwise penetrate the superconducting coils. Obviously, the radially closer the shielding rings are to the superconducting coils, the smaller can be the longitudinal extension.

It should be noted in this context that it has already been proposed to arrange superconducting coils in the vacuum vessel as multiple radial groups in different radial regions, wherein the most important superconducting coils (in particular the at least two main superconducting coils) are located in the radially innermost radial region, that is, very close to the gradient coil assembly and are hence subject to stray field problems. Since stray field strength significantly drops with increasing (radial) distance, superconducting coils located in outer radial groups may be less relevant or even irrelevant to the design considerations discussed here.

As discussed, by segmenting the conductive layer of the shielding assembly into shielding rings at least on the radially inner side, these shielding rings are not electrically conductively connected to each other, such that a segmented electrically conductive structure is provided. Hence, a large percentage of the stray fields of the gradient coil assembly will pass through electrical conductivity openings between the shielding rings, which is, however, not problematic since these are provided in the transparency regions. The provided additional degrees of freedom may, in preferred embodiments of the invention, be used to additionally reduce disturbance fields in the homogeneity volume.

In especially preferred embodiments, the shielding rings may be configured such that disturbance fields created by eddy currents induced by stray fields of the gradient coil assembly in at least one of the shielding rings are at least partly, in particular at least substantially, compensated by disturbance fields created by eddy currents induced by the stray fields in at least one other, in particular longitudinally adjacent, of the shielding rings. In electrically isolated segments of conductive material, in this case shielding rings, eddy currents will mainly run along the edges of the shielding rings and will run in opposite directions at opposite edges. Such high eddy currents along one edge will produce high magnetic fields in close vicinity, which will be used to locally shield the superconducting coils, ideally positioned close or even directly behind, by counteracting the stray fields. However, in the far field, disturbance fields from both edges may destructively superimpose at least partly, such that only modestly high magnetic field amplitudes will affect magnetic resonance imaging. Here, the homogeneity volume may be understood as being positioned in the far field, since, in usual designs, it will be at least 0.5 m away.

In concrete embodiments, for example, terms of a spherical harmonics series may be calculated when designing the shielding rings, wherein designs can be achieved in which dominant terms of the spherical harmonics series of neighboring shielding rings mostly cancel out in the homogeneity volume.

The shielding rings comprise at least one layer of electrically conductive material at a constant radius extending in longitudinal and circumferential direction. In particular, the shielding rings are positioned inside the superconducting coils of the main field coil assembly, that is, between the superconducting coils and the gradient coil assembly. Preferably, the shielding rings may be broader than a respective superconducting coil shielded by the shielding ring, in particular protruding 1 to 3 cm over the shielded superconducting coil in the longitudinal direction. That is, the extension of the shielding rings in longitudinal direction may be longer than the length of the superconducting coil which is being shielded. For example, the additional longitudinal extension of the shielding ring may be determined depending on the radial distance between the shielding ring and the associated superconducting coil. For example, the longitudinal length of the shielding ring can be equal to the longitudinal length of the superconducting coil to be shielded plus a factor multiplied with the radial distance between the shielding ring and the superconducting coil to be shielded. This factor, which may be object to optimization, for example as an optimization parameter can, for example, be 1 to 1.5.

In preferred embodiments, at least one of the shielding rings may comprise, at at least one longitudinal side, a radially extending shielding section. Such a shielding section may be shorter than the longitudinal shielding ring extension. In particular, the shielding section may at least be provided towards the middle of the patient bore. If such a shielding section is provided on one side of the shielding ring, an L-shaped cross-section results, if it is provided on both longitudinal ends of the shielding ring, a U-shaped cross-section results. Hence, instead of using flat cylindrically shaped shielding rings, the shielding rings may also comprise radially extending shielding sections to better shield respective superconducting coils from the stray fields coming from the respective side.

The electrical conductivity of the shielding rings' material should, in particular, be high enough to absorb most of the incoming stray fields for most of the relevant frequency range (or all of the relevant frequency range), but should also be high enough to provide a long time constant of the decay of the eddy currents induced by the stray fields of the gradient coil assembly, since long time constants of the decay of the eddy currents likely prevent disturbances at the magnetic resonance frequency. For example, the electrical conductivity of the electrically conductive material of the shielding rings may be larger than 3*10⁷ A/V/m.

In concrete embodiments, at least a part of the shielding rings may comprise, in particular pure, aluminum and/or copper as electrically conductive material. It is, however, also envisioned that at least a part of the shielding rings may comprise at least one superconducting material, which is superconductive at a temperature of the region where the shielding rings are located.

In this context, it is generally noted that a high electrical conductivity of the material of the shielding rings has a great number of advantages.

The eddy current skin depth reduces with frequency and conductivity. Since the excitation frequency is generally fixed according to the pulse sequence chosen, the eddy current skin depth can be reduced by increasing the conductivity. Hence, the thickness of the electrically conductive material of the shielding rings can be reduced whilst still providing enough material depth to allow all eddy currents. In other words, the amount of material for the shielding rings can be reduced. For example, the radial extension of the shielding rings may be less than 7.5 mm, for example 6 mm.

In addition to the electrical conductivity, the thermal conductivity also increases in proportion to the increase of the electrical conductivity. This is, in particular, advantageous if the component on or in which the shielding rings are implemented also has a cryogenic purpose. For example, the shielding rings may be provided on or as part of a thermal shield (cryoshield). Here, the necessary thermal conduction of heat loads may also be provided, in particular using less cryoshield material.

As already mentioned, with increasing electrical conductivity, the time constants for decay of the eddy currents also increase, meaning that the change of the disturbance field in the homogeneity volume due to decay of eddy currents will be reduced, providing a more time stable disturbance field during magnetic resonance imaging, in particular during a pulse sequence. The compensation of eddy currents is easier implementable as the rate of change of the disturbance fields is reduced. In particular, if eddy current compensation measures for linear disturbance fields are employed, the amplitude change of compensation currents is correspondingly reduced.

As already mentioned, these potential benefits all improve with the increase of the electrical conductivity of the material of the shielding rings. In particular, instead or in addition to a high "normal" electrical conductivity material, in particular a metal, a superconducting material may be used. Using a superconducting material in the form of a bulk or a thin film can provide high levels of electromagnetic shielding. In embodiments, the shielding rings can also be formed from a combination of superconducting and normally conducting materials, in particular if both great electromagnetic shielding properties and good thermal conduction of heat loads are needed, in particular for a thermal shield.

In preferred embodiments, as electrical conductivity also increases with decreasing temperature, the shielding rings may be provided at a cold position of the cryogenic assembly. In concrete embodiments, the shielding rings may be positioned at the superconducting coils, in particular in a low temperature region of a temperature below 5 K and/or inside an inner cooling medium vessel, for example helium vessel. Alternatively or additionally, the shielding rings may be positioned on or as part of a thermal shield enclosing the main field coil assembly in the vacuum vessel, in particular in a medium temperature region of a temperature less than 60 K. Hence, shielding rings can be provided, for example, on the superconducting coil level, for example at 4 K, and/or at the cryoshield level, which may, for example, have a temperature of about 50 K. In both cases, the low temperature in the cryogenic assembly is exploited to further increase the electrical conductivity, leading to the results mentioned above and, in particular, also allowing the use of superconducting materials. While, regarding proximity to the superconducting coils and temperature, positioning of the shielding rings in the low temperature region, for example at 4 K, may seem optimal, from a thermodynamical point of view, significant energy deposition in the shielding rings is expected, leading to higher cooling requirements, for example a cold head of higher power, whereas positioning the shielding rings in the medium temperature region, in particular on or as part of a thermal shield, has significantly lower thermodynamical requirements and has thus been determined as a particularly preferable position. In this context, the shielding rings may also be named "cryorings", since they are positioned on or as part of a cryoshield.

In concrete embodiments, for shielding rings on or as part of the thermal shield, the thermal shield may comprise, at least in regions between the shielding rings, an electrical isolator material, in particular fiber-reinforced isolator material. Hence, the shieling rings may be realized as part of a composite thermal shield (cryoshield), wherein, on the radially inner side, shielding rings and electrical isolator material are alternatingly used. Here, to provide sufficient stability, preferably fiber-reinforced isolator materials may be used.

In embodiments, at least two groups of shielding rings may be provided in a cascaded arrangement, wherein at least two coaxial corresponding shielding rings of the respective groups are provided at least substantially at the same longitudinal position and/or having the at least substantially same longitudinal extension. Hence, there could be more than one layer of shielding rings to further improve shielding for the superconducting coils. For example, one group of shielding rings may be located in the low temperature region, a second group may be located in the medium temperature region (cryoshield level) and a third group of shielding rings may be located in an ambient temperature region, in particular on and/or as part of the vacuum vessel (OVC level). In other embodiments, only two of those groups may be used. If such a cascading structure is chosen, it is advantageous if the shielding rings of each layer produce the same shape of eddy current field. Hence, the shielding rings of the different groups should be very similar or even identical in longitudinal extension (width) and longitudinal position.

If a first group of shielding rings is provided in the low temperature region, for example in an inner cooling medium vessel, and a second group is provided in the medium temperature region, in particular on or as part of the thermal shield, and/or a third group is provided in the ambient temperature region, in particular on or as part of the vacuum vessel, the radially inner shielding rings already absorb part of the stray field such that less heat is generated for the first group of shielding rings which may then require substantially no power increase regarding cooling in the inner cooling medium vessel, in particular a helium vessel.

In another advantageous embodiment, in particular if shielding rings in the low temperature region of the cryogenic assembly should be avoided, a first group may be provided as part of or on the thermal shield and a second group may be provided as part of the vacuum vessel. Also in this case, improved shielding is provided in a multi-layer approach.

In concrete embodiments, at least the radially outer side of the thermal shield and/or the vacuum vessel may be made from electrically conductive material, in particular the same material as the shielding rings. For example, conductive materials like steel, aluminum or the like, which have previously been used, may still be used radially outside from the main field coil assembly. Here, further shielding from and to the outside may be provided. Regarding the end faces, for the vacuum vessel, they may preferably be electrically conductive, for example made of steel. Regarding the thermal shield, both isolator materials and electrically conductive materials are conceivable for the longitudinal end faces.

As already discussed, the shielding rings may be configured such that at least some, in particular dominant, portions of disturbance fields caused by eddy currents cancel out for at least one pair of shielding rings, in particular adjacent rings. In particular, it can be shown that higher-order terms of a spherical harmonics series often cancel out due to opposing currents at opposing edges. In particular, designs are conceivable wherein at least substantially only linear disturbance fields remain, which may be compensated by respectively controlling the gradient coil assembly, which, as known, produces such linear fields. Hence, preferably, the magnetic resonance imaging device may further comprise a control device adapted to apply eddy current compensation regarding remaining linear disturbance fields caused by eddy currents induced by stray fields of the gradient coil assembly. Hence, regarding remaining linear disturbance fields, known ECC approaches may also be used in the current invention.

It is noted that transparency regions, which are a basic concept of the current invention, may be provided in reasonable sizes in particular for applications having a lower main field strength. Preferably, the invention may be applied to magnetic resonance imaging devices wherein the strength of the main field in the homogeneity region is 0.4 to 2 T, in particular 0.5 or 1.5 T.

In summary, the inventive concept of providing a simultaneous solution for both heat effects and disturbance effects allows to refrain from active shielding and hence from active shielding layers. This, in turn, allows for a significant cost reduction for magnetic resonance imaging devices by reducing the gradient coil assembly thickness notably, for example by 3 to 10 cm radially. In addition, not actively shielded gradient coil assemblies will produce just about 20 to 30 % of the losses compared to actively shielded gradient coil assemblies at the same performance level. Gradient coil infrastructure, in particular also regarding cooling, can be downsized, resulting in a less complicated construction. Furthermore, radially thinner gradient coil assemblies may allow higher effective patient bore diameters, providing more space for patients.

The invention further concerns a method for designing a shielding assembly for a magnetic resonance imaging device according to the invention, wherein at least a position and a longitudinal extension of the shielding rings as optimization parameters are determined in an optimization procedure to both minimize heat produced by eddy currents induced by stray fields of the gradient coil assembly in the cryogenic assembly and disturbance fields generated by eddy currents induced by stray fields of the gradient coil assembly in the homogeneity volume, wherein, as a boundary condition, the heat generation is limited to a predefined maximum. All features and remarks regarding the magnetic resonance imaging device according to the invention analogously apply to the design method, which may, in particular, be used in a method for manufacturing a magnetic resonance imaging device according to the invention, wherein the determined optimization results, that is optimal optimization parameters, are used to manufacture the magnetic resonance imaging device.

It should be noted at this point that corresponding boundary conditions may be applied regarding disturbance fields in the homogeneity volume. In particular, for both effects, it is accepted that neither perfect shielding of the superconducting coils nor perfect suppression of disturbance fields is possible. Instead, the performance of the magnetic resonance imaging device is taken into account to predefine corresponding boundaries in respective boundary conditions.

In concrete embodiments, the optimization procedure may comprise an electromagnetic simulation. Such simulations to calculate field distributions and/or eddy currents and/or heat dissipation have already been proposed in the state of the art and can also be applied here. For example, finite elements simulations may be used.

In embodiments, of course, further boundary conditions can be applied, for example regarding positions, extensions and the like. The optimization procedure may be based on a predefined stray field distribution of the gradient coil assembly. In some cases, there may be alternating optimization procedures. Embodiments may also provide simultaneous optimization of gradient coil properties and shielding assembly properties.

Furthermore, additional parameters of the shielding assembly may be used as optimization parameters in the optimization procedure. For example, the material used for all the shielding rings and/or each shielding ring may be introduced as an optimization parameter, as well as geometry parameters of radially extending shielding sections and the like.

In preferred embodiments, during the optimization procedure, coefficients of a spherical harmonics series describing disturbance fields by eddy currents induced by stray fields of the gradient coil assembly in the homogeneity volume can be determined. Herein, the optimization parameters may be determined such that certain terms of the spherical harmonics series of neighboring shielding rings at least substantially cancel out. In experiments and regarding first prototypes, it could be seen that, in many configurations, (n, 3) and (n, 5) terms of the spherical harmonics series had very low coefficients, while, for example (3, 1)-terms having larger coefficients were substantially cancelled out.

In summary, the inventive design method clearly shows how the additional degrees of freedom provided by the inventive approach allow to simultaneously find an optimal solution for both heat generation due to stray fields and disturbance of magnetic resonance imaging due to stray fields of the gradient coil assembly.

A conceivable computer program may perform the steps of a method according to the invention when the computer program is executed on a computing device. The computer program may be stored on an electronically readable storage medium, which hence comprises control information comprising the computer program, such that, when the electronically readable storage medium is used in a computing device, the computing device is enabled to perform the steps of a method according to the invention when the computer program is executed on the computing device.

Other objects and features of the present invention will become apparent from the following detailed description considered in conjunction with the accompanying drawings. The drawings, however, are only principle sketches designed solely for the purpose of illustration and do not limit the invention. The drawings show:
- Fig. 1: a schematical cross-sectional view of a first embodiment of a magnetic resonance imaging device according to the invention,
- Fig. 2: a schematical cross-sectional view of a second embodiment of a magnetic resonance imaging device according to the invention,
- Fig. 3: a schematical cross-sectional view of a third embodiment of a magnetic resonance imaging device according to the invention,
- Fig. 4: a detail explaining a first possible embodiment using shielding sections,
- Fig. 5: a detail view of a second possible embodiment using shielding sections, and
- Fig. 6: a flowchart explaining steps of a method according to the invention.

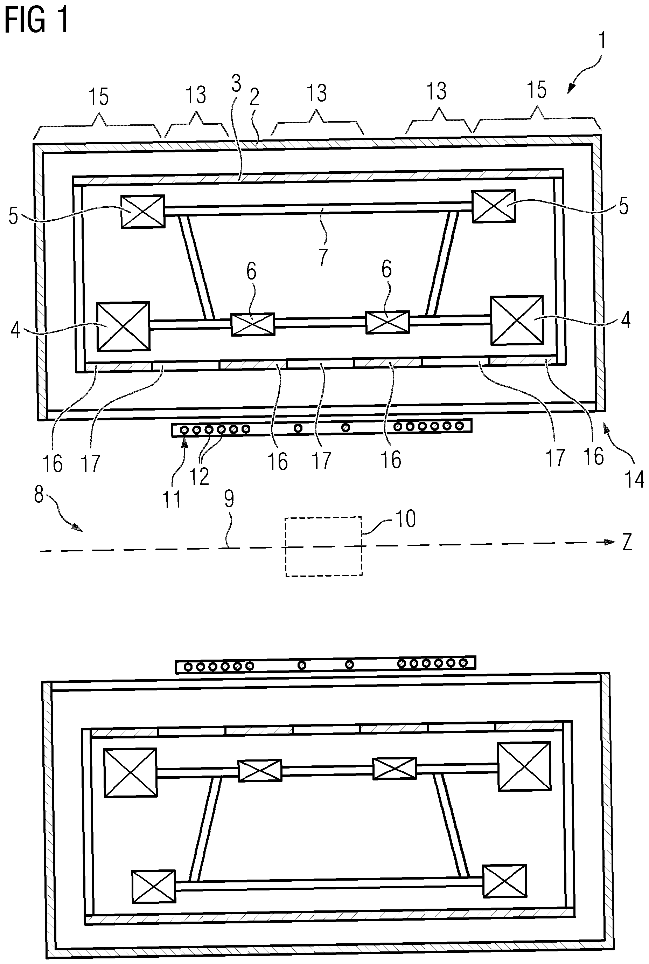

Fig. 1 is a schematical cross-sectional view of a magnetic resonance imaging device 1 in a first embodiment. The magnetic resonance imaging device 1 comprises a cryogenic assembly having an outer vacuum vessel 2, a thermal shield 3 (cryoshield) and an inner cooling medium vessel, in this case helium vessel, which is not shown in fig. 1. In the inner helium vessel, which is filled with liquid helium, superconducting coils 4, 5, 6 are supported by a support structure 7.

The outer vacuum vessel 2 defines a cylindrical patient bore 8 having a longitudinal direction 9, which is usually called Z direction. The horizontal direction orthogonal to the longitudinal direction 9 is usually called X direction, while the vertical direction orthogonal to the longitudinal direction 9 is usually called Y direction.

The superconducting coils 4, 5, 6 of the main field coil assembly generate a main field (main magnetic field, B0), in which the spins of an object to be imaged align. The main field has a certain homogeneity in a homogeneity volume 10, which forms the field of view of the magnetic resonance imaging device 1. To allow for field gradients during imaging, in particular regarding spatially resolved measurements, a cylindrical gradient coil assembly 11 is provided inside the patient bore 8, wherein the gradient coil assembly 11 comprises three gradient coils, indicated by their conductors 12, in particular one gradient coil to generate a field gradient in Z direction in the homogeneity volume 10 (Z coil), one gradient coil to generate a magnetic field gradient in the Y direction in the homogeneity volume 10 (Y coil) and one gradient coil to generate a magnetic field gradient in the X direction in the homogeneity volume 10 (X coil).

The Y coil and the X coil are also called transversal gradient coils.

Radially inwards from the gradient coil assembly 11, additionally, a radio frequency coil assembly may also be provided, for example a body coil and/or a birdcage coil. Such a radio frequency coil assembly (RF coil assembly) as well as other elements of the magnetic resonance imaging device 1, for example cover elements, the patient table and the like, are for simplicity not shown in the figures to focus onto the respective designs of the superconducting main field coil assembly, the cryogenic assembly and the gradient coil assembly 11.

The gradient coils, in particular the transversal gradient coils, do not only generate gradient fields in the homogeneity volume 10, but also stray fields, in particular also in the cryogenic assembly. Since the gradient coil assembly 11 is not actively shielded, in particular has no active shielding layer, these stray fields may have considerable strengths since they are not actively compensated. As already discussed, these stray fields of the gradient coil assembly 11 have mainly two effects, namely ohmic heating in the cryogenic assembly, in particular at the superconducting coils 4, 5 and 6, as a first effect and disturbance of magnetic resonance imaging by disturbance fields generated because of the eddy currents in the homogeneity volume 10. Generally speaking, the embodiments discussed here provide measures to simultaneously control both effects in a sufficient manner. As a result, active shielding of the gradient coil assembly 11 can be omitted.

As can be seen from fig. 1, the superconducting main field coil assembly comprises multiple superconducting coils 4, 5 and 6 arranged symmetrically in pairs (two main superconducting coils 4, two superconducting coils 5 and two superconducting coils 6) regarding the longitudinal direction 9. The arrangement of the superconducting coils 4, 5 and 6 is chosen such that there is superconducting coil-free space in longitudinal direction between longitudinally adjacent coils. These coil-free spaces are transparency regions 13, where, hence, eddy currents in superconducting coils cannot occur.

It is noted that the design of the main field coil assembly shown in these embodiments is only exemplary; in many cases, more superconducting coils may be used, sometimes resulting in a greater number of transparency regions. Further, two radially offset groups of superconducting coils 4, 5, 6 are shown, namely an inner radial group of superconducting coils 4 and 6 and an outer radial group of superconducting coils 5. The outer radial group is significantly farther away from the gradient coil assembly 11, such that stray fields will be very weak, in particular negligible. Hence, the following considerations may put lesser weight on the outer radial group or even classify it as irrelevant in some cases.

To further reduce the possibility of eddy currents at least radially inside from the superconducting coils 4, 5 and 6, electrically conductive materials are avoided as far as possible in the transparency regions 13. However, electrically conductive structures are possible, in particular if eddy currents inside these electrically conductive structures predominantly run in Z directions, as such eddy currents do not create disturbance fields relevant for the longitudinal direction 9 (Z direction). In particular, the support structure 7, at least in the transparency region 13, is, in this case, made from isolator materials, as is, in the first embodiment, the radially inner side 14 of the vacuum vessel.

In the embodiments shown here, the gradient coil assembly 11 is configured, in particular having been designed accordingly in an optimization process, such that the stray fields are directed mostly into the transparency regions 13. In particular, when designing the conductors and their course, additional boundary conditions can be formulated such that the field lines of the stray fields mostly run through the transparency regions 13. For example, at least 70 % of the magnetic field strength of the stray fields generated by the gradient coil assembly 11 in the cryogenic assembly may be generated in the transparency regions 13. In embodiments, the gradient coils of the gradient coil assembly 11, in particular the transversal gradient coils, may be configured such that the maximum magnetic field strength of their stray fields is higher in the transparency regions 13 of the vacuum vessel 2 than outside the transparency regions 13 in the vacuum vessel 2. Furthermore, the design may be such that the average magnetic field strength of the stray fields is higher in the transparency regions 13 of the vacuum vessel 2 than outside of the transparency regions 13 in the vacuum vessel 2 and/or the (maximum or average) magnetic flux through a defined area size may be higher in the transparency regions 13 of the vacuum vessel 2 than outside the transparency regions 13 in the vacuum vessel 2.

To explain a concrete design measure regarding the gradient coil assembly 11, in the embodiments known here, the superconducting coils 4 are main superconducting coils 4, since they generate the highest portion of the main field in the homogeneity volume 10 by, for example, having the most windings/the longest conductor. Such main superconducting coils 4 are usually positioned in opposing longitudinal end regions 15 of the cryogenic assembly. The conductors of at least the transversal gradient coils of the gradient coil assembly 11 now have a course such that they only extend in a longitudinal conductor region between the two longitudinal end regions. In other words, the gradient coil assembly 11 is shorter in the longitudinal direction 9 than the vacuum vessel 2, in particular by at least twice the longitudinal size of the longitudinal end regions 15. This can be achieved, for example, by locating return conductors, which are less relevant for the gradient field in the homogeneity volume 10, closer to each other. By having no conductors 12 of the gradient coil assembly 11 in the longitudinal end regions 15, the stray fields of the gradient coil assembly 11 will be significantly lower in these areas.

However, if the superconducting coils 4, 5, 6 would still be left unshielded, the stray fields would still induce eddy currents leading to heating and likely quenching. Hence, a shielding assembly is provided in the magnetic resonance imaging device 1, which exploits the fact that transparency regions 13 are present. In the embodiment of fig. 1, the shielding assembly comprises four shielding rings 16 made of electrically conductive material, for example pure aluminum or copper, and being longitudinally separated from each other in transparency regions 13. That is, gaps in the electrically conductive shielding of the superconducting coils 4, 5, 6 are present, which, however, lead to the transparency regions 13 where at least substantially no relevant eddy currents (leading to excessive heating and/or disturbance fields in the homogeneity volume) can be generated. The degrees of freedom won regarding positioning and extension of the shielding rings 16 in longitudinal direction can be exploited to reduce disturbance fields created by eddy currents running in the shielding rings 16 in the homogeneity volume 10.

Each shielding ring 16 is associated with one or more superconducting coils 4, 5, 6 (at least of the inner radial group) to be shielded by the corresponding shielding ring 16, that is superconducting coils 4, 5, 6 located radially outward behind the shielding rings 16, seen from the gradient coil assembly 11. Depending on how close the shielding ring 16 is to the corresponding superconducting coil 4, 5, 6 (in particular of the inner radial group), they may project longitudinally over the longitudinal extension of the respective superconducting coils 4, 5, 6.

It is, again, noted that in the embodiments shown here, the (small) superconducting coils 5 are farther away from the gradient coil assembly 11 and hence can, in some cases, be disregarded when designing the shielding rings 16, since the stray fields in these radial regions are significantly lower.

Regarding the shielding rings 16 protruding over the longitudinal extension of the associated superconducting coils 4, (5,) 6, the additional length of the shielding rings 16 may be determined by the distance between the shielding ring 16 and the superconducting coil 4, (5,) 6 which is being shielded. For example, the longitudinal length of the shielding rings 16 can be determined as the longitudinal length of the shielded superconducting coil 4, 5, 6 plus the radial distance to the superconducting coil 4, 6 multiplied with the factor, which can, for example, be in the range of 1 to 1.5. Here, the superconducting coils 5 are located radially behind superconducting coils 4 and hence also shielded by the corresponding shielding ring 16, while, of course, the distance to the closest superconducting coils 4 is relevant here. It is noted that, in other designs of the main field coil assembly, more shielding rings, for example six to eight shielding rings, may be used.

The shielding rings 16 form electrically isolated segments of electrically conductive materials, wherein eddy currents will mainly run along the edges of such segments and will run in opposite directions at opposite edges. While high eddy currents will generate high magnetic fields in close vicinity, which are used to locally shield the superconducting coils 4, 5, 6, however, in the far field, in particular, in this case, in the homogeneity volume being at least 0.5 m away, magnetic fields from the opposing edges will destructively superimpose at least partly. Hence, remaining disturbance fields have a lower amplitude. In particular, the concrete position and longitudinal extension of the shielding ring 16 may be determined in an optimization procedure, wherein both the heat generated by the eddy currents of the stray fields and the disturbance fields, in particular the non-linear disturbance fields, are minimized, as will be further discussed below. In particular, terms of a spherical harmonics series may be determined and the geometry may be chosen such that specific, high-amplitude terms of neighboring shielding rings 16 cancel out.

As the shielding rings 16 have a high conductivity, their thickness in radial direction can be low, for example 7.5 mm or less.

In the embodiment of fig. 1, shielding rings 16 are provided as part of the thermal shield 3, wherein, between the shielding ring 16, isolator material, for example fiber-reinforced isolator material, is located in the form of isolator rings 17. That is, the shielding rings 16 are located in a medium temperature region of the cryogenic assembly, for example at around 50 K. At such low temperatures, the electrical conductivity is additionally increased. While it would be possible (and optimal regarding the electromagnetic shielding effect) to provide the shielding rings 16 in the low temperature region of the cryogenic assembly, for example at around 4 K, in particular adjacent to the superconducting coils 4, 5, 6, this would significantly raise the thermodynamic requirements, since the eddy currents induced in the electromagnetic shielding process generate heat which the cold head (not shown in the figures) would have to work against. Hence, positioning the shielding rings 16 has been found to be a preferable compromise. The shielding rings 16 in the first embodiment of fig. 1 can also be called cryorings. By choosing aluminum and/or copper as electrically conductive materials, also the thermal conduction and shielding properties of the thermal shield 3 can be achieved.

It is noted at this point that it is also conceivable, in particular if shielding rings 16 are placed in the low temperature region, to at least partially use a superconducting material as shielding material of the shielding rings 16, or a combination of high, but normal electrical conductivity material like aluminum or copper and superconducting materials to provide thermodynamic properties as well as improved electromagnetic shielding properties.

In all embodiments shown, the radially outer sides of the vacuum vessel 2 and the thermal shield 3 are, as indicated by the shading, electrically conductive, wherein, for the thermal shield 3, the same electrically conductive material as for the shielding rings 16 is used. For the vacuum vessel 2, steel may be used. Regarding the longitudinal end faces, the vacuum vessel 2 is still electrically conducting, while, in this case, for the thermal shield 3, isolator material has been used. In the embodiment of fig. 1, furthermore, the material at the radially inner side 14 of the vacuum vessel 2 is an isolator material.

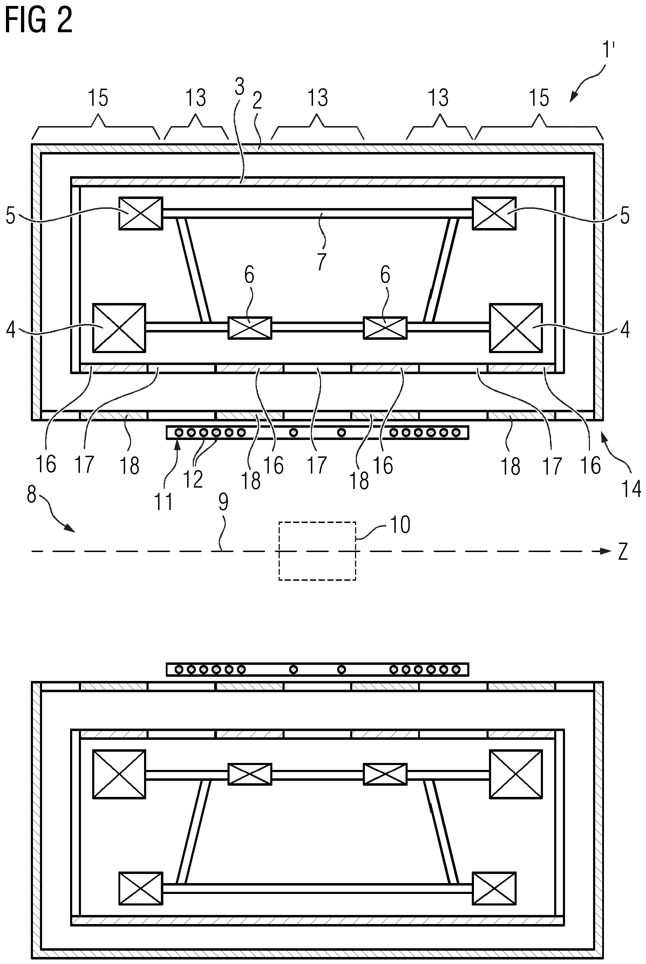

Fig. 2 shows a slightly modified embodiment of a magnetic resonance imaging device 1', wherein like components have the same reference numerals and will not be described in detail here. In this second embodiment, in addition to the shielding rings 16, which form a first group of shielding rings 16, a second group of shielding rings 18 have been added at the radially inner side 14 as part of the vacuum vessel 2. Since they are at least substantially at the same position and have substantially the same longitudinal extension, a cascaded design is provided.

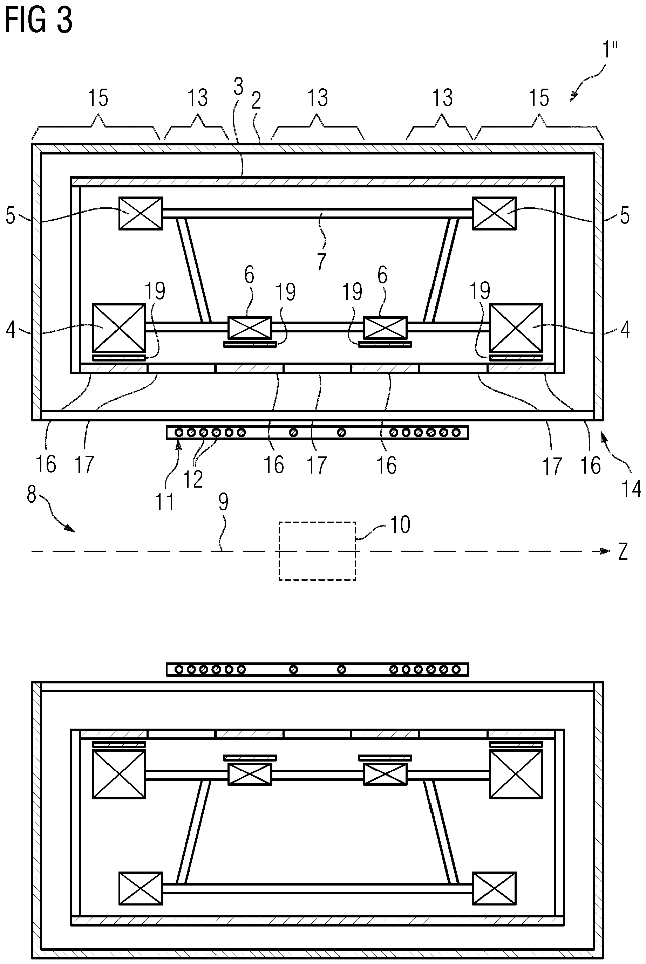

In the third embodiment of a magnetic resonance imaging device 1'' according to fig. 3, an additional group of shielding rings 19 has been provided in the low temperature region, in particular close to or directly adjacent to superconducting coils 4 and 6. In such a configuration, superconducting material may be employed in the shielding rings 19 since the shielding rings 16 (and optionally additionally the shielding rings 18) have a pre-shielding function such that only low-amplitude remains of the stray field generate eddy currents in the shielding rings 19, leading to low generated heat.

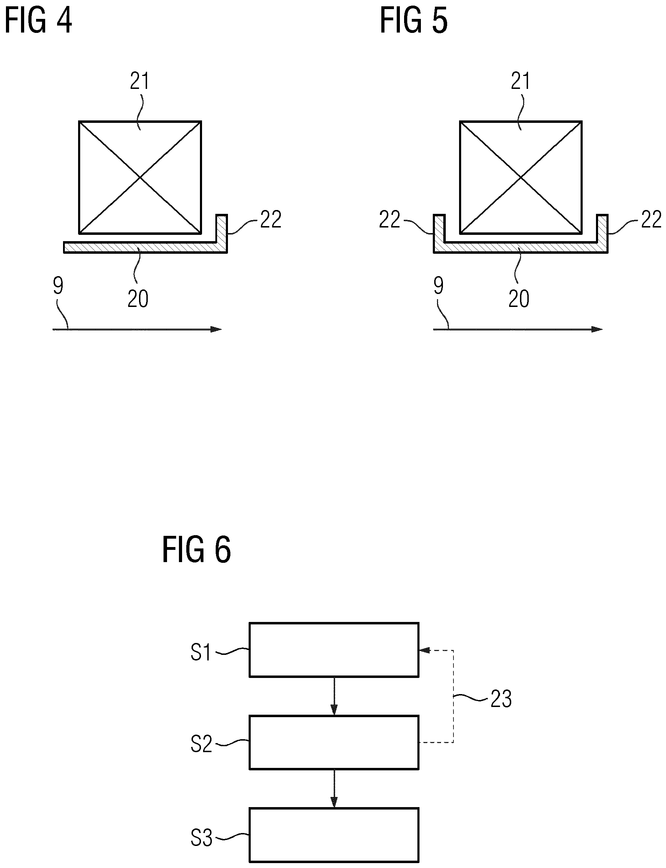

Fig. 4 and fig. 5 show possible modifications of shielding rings 20 regarding a superconducting coil 21 to be shielded, which can be employed in the embodiments of figures 1 to 3. According to fig. 4, the shielding ring 20 comprises, at its longitudinally inner end, that is, the end closer to the homogeneity volume 10, a radially extending shielding section 22. Hence, a cross-sectional L-shape results. According to fig. 5, shield sections 22 can also be provided on both longitudinal ends of the shielding ring 20 to result in a cross-sectional U-shape. In this manner, the superconducting coil 21 can be better electromagnetically shielded from stray fields coming from the sides.

Generally speaking, in these embodiments, the geometry of the single shielding rings 16, 18, 19, 20, in particular their positions and longitudinal extensions, were optimized in an optimization procedure such that the superposition of the eddy current fields generated by all the shielding rings results in an at least substantially linear disturbance field in the homogeneity volume 10, wherein higher order field components cancel out due to destructive superposition as good as possible. Regarding the remaining linear disturbance field, eddy current compensation may be provided for the gradient coil assembly 11 by correspondingly modifying currents and/or voltages for the gradient coils. A control device of the magnetic resonance imaging device 1, 1', 1" (not shown in the figures) may be configured to apply the eddy current compensation regarding the linear disturbance fields.

At least the position and longitudinal extension of the shielding rings 16, 18, 19, 20 as optimization parameters may be determined in an optimization procedure such that heating is kept in bounds, in particular preventing a quench, and at least non-linear disturbance fields and heating are kept as low as possible. Of course, additional optimization parameters, for example regarding the material of the shielding rings 16, 18, 19, 20, the geometry of shielding sections 22, and the like may be used.

In the flowchart of fig. 6, in a step S1, a predefined stray fields distribution is provided, based on a respective design of the gradient coil assembly 11. In particular, this design may have been determined by an optimization algorithm based on sufficient linearity in the homogeneity volume 10 and directing the stray fields mostly to the transparency regions 13.

In a step S2, these predefined stray fields distribution is used in an optimization procedure to determine optimized optimization parameters, at least comprising position and longitudinal extension of the shielding rings 16, 18, 19, 20. As a boundary condition, the heat generation should be limited to a predefined maximum such that quenches cannot occur. While, when using this boundary condition, it is theoretically conceivable that the target function of the optimization procedure only comprises the minimization of disturbance fields, in particular non-linear disturbance fields, the generated heat will, in this embodiment, also be minimized, wherein weighing of the respective terms of the target function may be employed. Further boundary conditions may, of course, also be introduced.

To determine heat generation and disturbance fields, simulations are performed, in particular based on the finite elements approach. During optimization, in particular, a spherical harmonics series expansion is performed regarding the disturbance fields, such that high-amplitude higher order terms can be identified and the optimization parameters can be adapted to better cancel out these terms in the homogeneity volume 10.

It is possible to iterate the process of steps S1 and S2 as indicated by arrow 23, that is, the gradient coil assembly 11 and the shielding assembly can be successively and alternatingly optimized until a global optimum is achieved. It is, however, also conceivable to include an optimization of the gradient coils of the gradient coil assembly 11 into the optimization procedure, but less preferred due to the high complexity and risk to run into nonsensical solutions.

In step S3, the optimization results of step S2 can be used to manufacture the magnetic resonance imaging device 1, 1', 1" accordingly.

Although the present invention has been described in detail with reference to the preferred embodiment, the present invention is not limited by the disclosed examples from which the skilled person is able to derive other variations without departing from the scope of the invention.

## Claims

1. Magnetic resonance imaging device (1, 1', 1"), comprising
- a superconducting main field coil assembly inside a vacuum vessel (2) of a cryogenic assembly, wherein the vacuum vessel (2) defines a cylindric patient bore (8), in which a homogeneity volume (10) of a main field created by the superconducting main field coil assembly is located, and
- an, in particular not actively shielded, cylindrical gradient coil assembly (11) having at least one gradient coil and being located inside the patient bore (8), wherein the cryogenic assembly comprises a shielding assembly to shield the main field coil assembly from stray fields of the gradient coil assembly (11),
**characterized in that**
- the main field coil assembly comprises multiple superconducting coils (4, 5, 6, 21) successively arranged inside the vacuum vessel (2) along a longitudinal direction (9) of the patient bore (8), wherein at least one pair of superconducting coils (4, 5, 6, 21) are distanced in the longitudinal direction (9) to form a longitudinally extending transparency region (13), and
- the shielding assembly comprises multiple shielding rings (16, 18, 19, 20) pairwise longitudinally separated by one of the at least one transparency region (13).

2. Magnetic resonance imaging device (1, 1', 1") according to claim 1, **characterized in that** the gradient coils of the gradient coil assembly (11) are, in particular based on an optimization result, configured such that the stray fields are mainly located in the at least one transparency region (13), in particular such that at least 70 % of the magnetic field strength is generated in the transparency region (13).

3. Magnetic resonance imaging device (1, 1', 1") according to claim 1 or 2, **characterized in that** the superconducting coils (4, 5, 6, 21) comprise at least two main superconducting coils (4, 21) located in opposing longitudinal end regions (15) of the cryogenic assembly, wherein the conductors (12) of at least the transversal gradient coils of the gradient coil assembly (11) only extend in a longitudinal conductor region between the two longitudinal end regions (15).

4. Magnetic resonance imaging device (1, 1', 1") according to one of the preceding claims, **characterized in that** all components of the cryogenic assembly inside the transparency region (13) are configured such that at least eddy currents due to stray fields of the gradient coil assembly (11), which create, in particular non-compensable, disturbance fields, in particular of order higher than one, disturbing the magnetic resonance imaging, in particular all eddy currents due to stray fields of the gradient coil assembly (11), are at least partially prevented, in particular at least substantially prevented.

5. Magnetic resonance imaging device (1, 1', 1") according to one of the preceding claims, **characterized in that** at least a part of components, in particular all components, of the cryogenic assembly comprise no electrically conductive material or only electrically conductive material, in which the time constant the decay of eddy currents induced by stray fields of the gradient coil assembly (11) is smaller than a threshold value, in particular 2 ms, in each transparency region (13) and/or electrically conductive material in the at least one transparency region (13) extends mainly in the longitudinal direction (9), in particular has a radial or circumferential extension of less than 5 mm.

6. Magnetic resonance imaging device (1, 1', 1") according to one of the preceding claims, **characterized in that** the shielding rings (16, 18, 19, 20) are configured such that disturbance fields created by eddy currents induced by stray fields of the gradient coil assembly (11) in at least one of the shielding rings (16, 18, 19, 20) are at least partly, in particular at least substantially, compensated by disturbance fields created by eddy currents induced by the stray fields in at least one other of the shielding rings (16, 18, 19, 20) .

7. Magnetic resonance imaging device (1, 1', 1") according to one of the preceding claims, **characterized in that** the shielding rings (16, 18, 19, 20) are broader than a respective superconducting coil (4, 5, 6, 21) shielded by the shielding ring, in particular by the radial distance to an associated superconducting coil (4, 5, 6, 21) to be shielded multiplied with a factor, in particular of 1 to 1.5, and/or protruding one to three centimeters over the shielded superconducting coil (4, 5, 6, 21) and/or that at least one of the shielding rings (16, 18, 19, 20) comprises, at at least one longitudinal side, a radially extending shielding section (22) .

8. Magnetic resonance imaging device (1, 1', 1") according to one of the preceding claims, **characterized in that** at least a part of the shielding rings (16, 18, 19, 20) comprise, in particular pure, aluminum and/or copper as electrically conductive material and/or at least one superconducting material, which is superconductive at a temperature of the region where the shielding rings (16, 18, 19, 20) are located.

9. Magnetic resonance imaging device (1, 1', 1") according to one of the preceding claims, **characterized in that** the shielding rings (16, 18, 19, 20) are positioned at the superconducting coils (4, 5, 6, 21), in particular in a low temperature region of a temperature below 5 K, and/or at or as part of a thermal shield (3) enclosing the main field coil assembly in the vacuum vessel (2), in particular in a medium temperature region of a temperature less than 60 K, and/or that the radial extension of the shielding rings (16, 18, 19, 20) is less than 7.5 mm.

10. Magnetic resonance imaging device (1, 1', 1") according to claim 9, **characterized in that**, for shielding rings (16, 18, 19, 20) at or as part of the thermal shield (3), the thermal shield (3) comprises, at least in regions between the shielding rings (16, 18, 19, 20), an electrical isolator material, in particular fiber-reinforced isolator material.

11. Magnetic resonance imaging device (1, 1', 1") according to claim 9 or 10, **characterized in that** at least two groups of shielding rings (16, 18, 19, 20) are provided in a cascaded arrangement, wherein at least two coaxial corresponding shielding rings (16, 18, 19, 20) of the respective group are provided at least substantially at the same longitudinal position and/or having at least substantially the same longitudinal extension.

12. Magnetic resonance imaging device (1, 1', 1") according to claim 11, **characterized in that** a first group is provided as part of the thermal shield (3) and a second group is provided as part of the vacuum vessel (2).

13. Magnetic resonance imaging device (1, 1', 1") according to one of the claims 9 to 12, **characterized in that** at least the radially outer side of a thermal shield (3) and/or the vacuum vessel (2) are made from electrically conductive material, in particular the same material as the shielding rings (16, 18, 19, 20).

14. Magnetic resonance imaging device (1, 1', 1") according to one of the preceding claims, **characterized in that** it further comprises a control device adapted to apply eddy current compensation regarding remaining linear disturbance fields caused by eddy currents induced by stray fields of the gradient coil assembly (11).

15. Method for designing a shielding assembly for a magnetic resonance imaging device (1, 1', 1") according to one of the preceding claims, wherein at least a position and a longitudinal extension of the shielding rings (16, 18, 19, 20) as optimization parameters are determined in an optimization procedure to both minimize heat produced by eddy currents induced by stray fields of the gradient coil assembly (11) in the cryogenic assembly and disturbance fields by eddy currents induced by stray fields of the gradient coil assembly (11) in the homogeneity volume (10), wherein, as a boundary condition, the heat generation is limited to a predefined maximum.
